Europäisches Patentamt

European Patent Office

Office européen des brevets

(11) Veröffentlichungsnummer: **0 481 104 A1**

## (12) EUROPÄISCHE PATENTANMELDUNG

(21) Anmeldenummer: **90119745.9**

(22) Anmeldetag: **15.10.90**

(51) Int. Cl.5: **G01R 15/02**

(43) Veröffentlichungstag der Anmeldung:
**22.04.92 Patentblatt 92/17**

(84) Benannte Vertragsstaaten:
**AT BE CH DE ES FR GB GR IT LI NL SE**

(71) Anmelder: **SIEMENS AKTIENGESELLSCHAFT**
**Wittelsbacherplatz 2**
**W-8000 München 2(DE)**

(72) Erfinder: **Steinmüller, Günter, Dipl.-Ing.(FH)**
**Laufamholz-Strasse 65**
**W-8500 Nürnberg(DE)**
Erfinder: **Windsheimer, Klaus, Dipl.-Ing.(FH)**
**Burgambach 24**
**W-8533 Scheinfeld(DE)**

(54) **Messwertumformer für elektronische Elektrizitätszähler.**

(57) Der Stromwandler eines elektronischen Elektrizitätszählers hat einen U-förmigen Netzstromleiter, dessen Wechselfeld die Wicklung einer zwischen seinen Schenkeln angeordneten Meßspule schneidet, wobei die Meßspule (2; 7; 10) einen ferromagnetischen Kern (4; 6; 8a, 8b) besitzt, der den magnetischen Weg zwischen einer als Mantelkern wirkenden, die Netzstromleiter und die Meßspule umgebenden magnetischen Abschirmung (3) bis auf einen Luftspalt solcher Größe schließt, daß keine Sättigung des ferromagnetischen Materials eintritt.

FIG 1

Die Erfindung betrifft einen Meßwertumformer für elektronische Elektrizitätszähler zur Umwandlung des Verbraucherstromes in eine von elektronischen Komponenten verarbeitbare verbraucherstromproportionale elektrische Meßgröße nach dem Oberbegriff des Patentanspruches 1.

Elektronische Zähler der vorgenannten Art benötigen zur Ermittlung des Energieverbrauches Meßwertumformer, die den Verbraucherstrom in elektrische Größen umwandeln, die von elektronischen Komponenten weiterverarbeitet werden können. Dazu ist es erforderlich, Verbraucherströme im Amperebereich in Meßströme oder Meßspannungen im mA- bzw. mV-Bereich umzuwandeln. Darüber hinaus müssen bei Drehstromzählern die Meßwertumformer eine sichere Potentialtrennung zwischen dem Netz und den elektronischen Komponenten gewährleisten. Eine weitere Forderung ist die Unempfindlichkeit gegen äußere magnetische Störfelder und die Unabhängigkeit der Umwandlung von einer eventuellen Gleichstromvormagnetisierung.

Aus dem Stand der Technik sind verschiedene Möglichkeiten zur Erfüllung der vorgenannten Forderungen bekannt. So ist beispielsweise aus der DE-PS 36 19 423 eine Stromwandleranordnung bekannt, bei der der Primärleiter als gefalteter Flachleiter mit gegenüberliegenden Leiterabschnitten ausgebildet ist, der mit zwei schleifenförmigen Ausnehmungen versehen ist, die je eine Stromschleife bilden. Jeder Stromschleife ist eine mit 50% der insgesamt vorhandenen Windungen versehene gegensinnig gewickelte Meßspule zugeordnet. Beide Meßspulen sind zwischen den beiden hin- und rückleitenden Flachleitern angeordnet, die aus magnetisch abschirmendem Material bestehen. Auf diese Weise soll erreicht werden, daß die Meßspulen weitgehend von magnetischen Fremdfeldern abgeschirmt sind und die Restwirkung durch die gegensinnige wicklung der beiden Meßspulen kompensiert wird. Diese Anordnung ist verhältnismäßig aufwendig und raumgreifend und liefert außerdem wegen der geringen magnetischen Kopplung aufgrund des fehlenden Kerns aus ferromagnetischem Material zwischen Primärwicklung und Sekundärspulen nur sehr geringe Ausgangssignale.

Aus der EP-A-0 262 293 ist ein Meßwandler der vorbeschriebenen Art bekannt, dessen Meßspule als flache Luftspule ausgebildet ist, die in dem Raum zwischen den Schenkeln eines U-förmigen, den Verbraucherstrom führenden Netzstromleiters in möglichst engem Kontakt zu diesem angeordnet ist. Der Nachteil dieser Meßwandleranordnung besteht vor allem darin, daß die Meßspule, um von möglichst vielen magnetischen Feldlinien des Netzleiters geschnitten zu werden, d.h. eine möglichst hohe Ausgangsspannung an der Meßspule zu erreichen, räumlich so eng wie möglich am Netzstromleiter angeordnet sein muß. Nachdem die Meßspule aber andererseits bei Drehstromzählern gegenüber dem Netzstromleiter sehr gut isoliert sein muß, ist dieses Ziel einer engen Kopplung nur sehr begrenzt zu erreichen. Durch eine relativ komplizierte, verflochtene Leitungsführung des Netzstromleiters im Meßspulenbereich können die Kopplungsverhältnisse zwar verbessert werden. Nachteilig dabei ist jedoch der relativ hohe Aufwand dieser Anordnung, zumal diese zur Abschirmung gegen die Einwirkung äußerer Magnetfelder von einer ferromagnetischen Abschirmung umgeben sein muß.

Der Erfindung liegt die Aufgabe zugrunde, einen Meßwertumformer zu schaffen, bei dem es möglich ist, einen hohen Wirkungsgrad, d.h. eine möglichst hohe Durchdringung des vom Netzstromleiter erzeugten Magnetfeldes in der Meßspule zu erreichen, ohne den Netzstromleiter in komplizierter Weise verlegen und einen hohen Isolationsaufwand betreiben zu müssen.

Diese Aufgabe wild durch die im Patentanspruch 1 angegebene Erfindung gelöst. Dadurch ist erreicht, daß das vom Netzstromleiter im Bereich der Meßspule erzeugte Magnetfeld ohne allzu große räumliche Einengung die Meßspule mindestens nahezu vollständig durchdringt. Dabei ist es nicht erforderlich, die Meßspule besonders flach zu gestalten und ein extrem hochwertiges Isoliermaterial zu verwenden, so daß der Gesamtaufwand gegenüber dem vorgenannten Stand der Technik erheblich reduziert werden kann.

Gemäß einer Weiterbildung der Erfindung nach Patentanspruch 2 kann der ferromagnetische Kern selbst als Spulenkörper ausgebildet sein, der die Meßspule als Wickelkörper trägt. Dadurch ist eine weitere Reduzierung des Aufwandes durch Einsparung eines zusätzlichen Wickelkörpers erreicht.

In der Ausbildung nach Patentanspruch 3 ist der ferromagnetische Kern an den Stirnseiten der Magnetspule kegelförmig nach außen aufgeweitet, so daß die Austrittsfläche der Feldlinien aus dem ferromagnetischen Abschirmkörper in Richtung auf die Meßspule vergrößert und der magnetische Widerstand in den Randbereichen vermindert wird. Diese Maßnahme verringert die Anzahl der außerhalb des Kernbereiches austretenden, die Meßspule nicht durchdringendem Feldlinien.

Gemäß Patentanspruch 4 besteht auch die Möglichkeit, einen im Längsschnitt doppel-T-förmigen Kern zu verwenden und diesen beidseitig in die Kernöffnung der Spule einzuschieben. Dadurch ist es möglich, die Meßspule unabhängig vom Kern zu wickeln und diesen mit dem Vorteil der Aufweitung des Durchmessers an den Stirnseiten in die fertige Meßspule einzuführen.

Weitere Einzelheiten der Erfindung werden anhand von Ausführungsbeispielen im folgenden näher erläutert. Es zeigen:

Fig. 1    den Querschnitt eines Meßwertumformers mit den Merkmalen der Erfindung,

Fig. 2    einen Längsschnitt des Meßwertumformers,

Fig. 3    einen Längsschnitt durch eine Ausführungsform einer Meßspule mit nach außen aufgeweitetem ferromagnetischen Kern, und

Fig. 4    einen Längsschnitt durch eine Meßspule mit geteiltem, doppel-T-förmigem ferromagnetischen Kern.

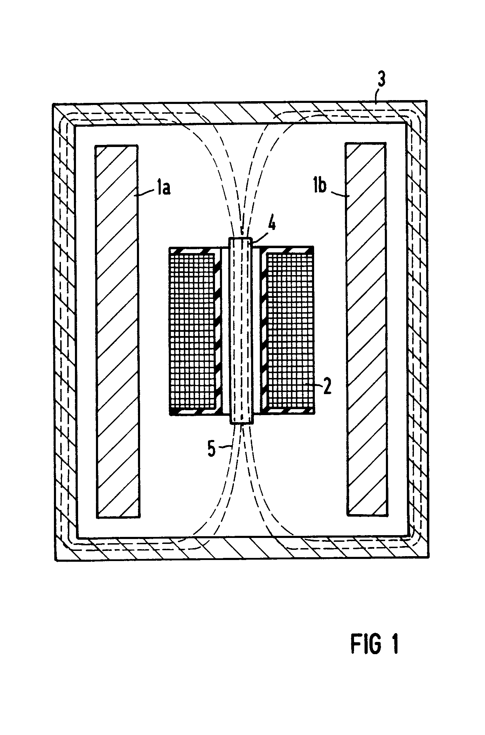

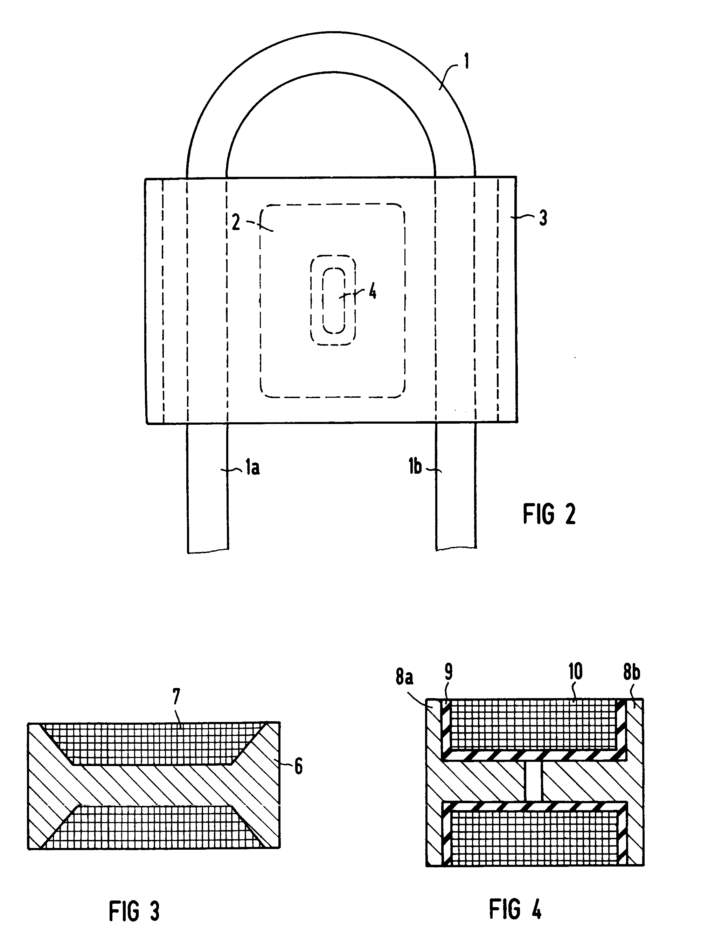

Bei der in Fig. 1 in einer Querschnittsdarstellung gezeigten Ausführungsform eines Meßwertformers nach der Erfindung bilden die beiden Stromleiter 1a und 1b die Hin- und Rückleitung eines U-förmig geführten Netzstromleiters, dessen Stromstärke gemessen und in einer nicht dargestellten elektronischen Schaltungsanordnung in bekannter Weise als Elektrizitätszählergröße verarbeitet werden soll. Die Schleifenführung ist in der Draufsicht nach Fig. 2 erkennbar. Die Größe des im Netzstromleiter 1 fließenden Stromes wird mit Hilfe eines Stromwandlers durch Messung des als Folge des Stromflusses den Netzstromleiter umgebenden magnetisches Feldes ermittelt. Zur Messung dieses magnetischen Feldes dient eine Meßspule 2, die zwischen den Schenkeln des Netzstromleiters 1 so angeordnet ist, daß diese von einer möglichst großen Anzahl der den Netzstromleitern 1 umgebenden magnetischen Feldlinien geschnitten wird. Um magnetische Fremdfelder von der Meßspule 2 fernzuhalten, ist diese zusammen mit dem Netzstromleiter 1 von einer ferromagnetischen Abschirmung 3 umgeben.

Der in den Netzstromleitern 1a, 1b in Hin- und Rückrichtung fließende zu messende Netzstrom erzeugt ein magnetisches Wechselfeld, welches in der ferromagnetischen Abschirmung 3 konzentriert wird. Da der in den Netzstromleitungen 1a und 1b fließende Netzstrom wegen der Stromrichtungsumkehr entgegengesetzt gerichtete magnetische Wechselfelder erzeugt, treten die Magnetfeldlinien 5 aus der einen Seite der Abschirmung 3 zwischen den Netzstromleitern aus, durchqueren den freien Raum, durchsetzen dabei die Meßspule 2 und treten in die gegenüberliegende Seite der Abschirmung 3 wieder ein. Um die in den freien Raum austretenden Feldlinien so zu bündeln, daß die Meßspule 2 von einer möglichst großen Anzahl dieser Feldlinien geschnitten wird und demzufolge einen möglichst hohen Meßstrom erzeugt, besitzt diese Spule einen ferromagnetischen Kern 4 solcher Abmessungen, daß zwischen den Stirnflächen dieses Kernes und den gegenüberliegenden Flächen der Abschirmung 3 Luftspalte bestehen. Der magnetische Kreis ist also aus der ferromagnetischen Abschirmung 3, dem ferromagnetischen Kern 4 und den beiden zwischen diesen angeordneten Luftspalten gebildet. Diese dienen dazu, eine Sättigung des ferromagnetischen Materials und/oder dessen Vormagnetisierung beim Auftreten eventueller Gleichstromkomponenten und dadurch ausgelöste Meßfehler zu verhindern. Andererseits wird durch den ferromagnetischen Kern 4 erreicht, daß der magnetische Widerstand innerhalb des magnetischen Kreises derart verringert wird, daß sich nur wenige magnetische Feldlinien außerhalb der Meßspule bewegen und an der Erzeugung des Meßstromes nicht beteiligt sind. Dies bedeutet, daß der Wirkungsgrad des Meßwertumformers gegenüber einer Luftspule erheblich verbessert ist. Es ist demzufolge auch nicht erforderlich, die Meßspule eng anliegend zwischen den beiden Netzstromleitern 1a und 1b anzuordnen, was einen hohen Isolationsaufwand erfordert. Außerdem kann auf eine fabrikationstechnisch aufwendige, extrem langgestreckte Form der Meßspule mit dem Ziel eines möglichst hohen Feldliniendurchsatzes verzichtet werden.

Eine weitere Vereinfachung und Verbesserung kann, wie in Fig. 3 dargestellt, dadurch erzielt werden, daß ein ferromagnetischer Kern 6 verwendet wird, der an den Stirnseiten der Meßspule 7 kegelförmig nach außen aufgeweitet ist. Der ferromagnetische Kern 6 dient dann gleichzeitig als Spulenkörper und die Aufweitung nach außen verringert den magnetischen Widerstand in den Randbereichen des Luftspaltes und bewirkt damit ein besseres "Einsammeln" der aus der ferromagnetischen Abschirmung 3 austretenden magnetischen Feldlinien mit der Folge einer Verbesserung des Wirkungsgrades des Meßwertumformers. In der Ausführungsform nach Fig. 4 ist ein doppel-T-förmig ausgebildeter Kern 8a, 8b benutzt, der ähnliche Vorteile aufweist, wie der Kern nach Fig. 3 verbunden mit der Möglichkeit, eine auf einem normalen Wickelkörper 9 angeordnete Meßspule 10 zu verwenden.

**Patentansprüche**

1.   Meßwertumformer für elektronische Elektrizitätszähler zur Umwandlung des Verbraucherstromes in eine von elektronischen Komponenten verarbeitbare verbraucherstromproportionale elektrische Meßgröße, bei dem das den verbraucherstromdurchflossenen elektrischen Netzstromleiter umgebende elektromagnetische Wechselfeld die Wicklung einer Meßspule schneidet und in dieser eine Meßspannung induziert und der Netzstromleiter eine U-förmige Schleife bildet, zwischen deren Schenkel die Meßspule elektrisch vom Netzstromleiter isoliert so angeordnet ist, daß diese von magnetischen Kraftlinien des Netzstromleiters geschnitten wird und der Netzstromleiter im Bereich der Meßspule von einer magnetischen Abschirmung gegen die Einwirkung äußerer Magnetfelder umgeben ist, die gleichzeitig als magnetischer Leiter für das vom Netzstromleiter erzeugte magnetische Feld dient, **dadurch gekennzeichnet**, daß die Meßspule (2; 7; 10) einen ferromagnetischen Kern (4; 6; 8a, 8b) besitzt, der den magnetischen Weg zwischen der als Mantelkern wirkenden magnetischen Abschirmung (3) und dem ferromagnetischen Kern (4; 6; 8a, 8b) bis auf einen Luftspalt solcher Größe schließt, daß keine Sättigung des ferromagnetischen Kerns (4; 6; 8a, 8b) eintritt.

2. Meßwertumformer nach Anspruch 1, **dadurch gekennzeichnet**, daß der ferromagnetische Kern (4; 6) selbst als Spulenkörper ausgebildet ist, der die Meßspule (2; 7) als Wickelkörper trägt.

3. Meßwertumformer nach Anspruch 2, **dadurch gekennzeichnet**, daß der ferromagnetische Kern (6) an den Stirnseiten der Meßspule (7) kegelförmig nach außen aufgeweitet ist.

4. Meßwertumformer nach Anspruch 1, **dadurch gekennzeichnet**, daß der ferromagnetische Kern (8a, 8b) im Querschnitt geteilt und im Längsschnitt doppel-T-förmig ausgebildet ist.

FIG 1

**FIG 2**

**FIG 3**

**FIG 4**

**Europäisches Patentamt**

# EUROPÄISCHER RECHERCHENBERICHT

Nummer der Anmeldung

**EP 90 11 9745**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 082 082  (LA TELEMECANIQUE)<br>* Zusammenfassung; Seite 7, Zeile 3 - Seite 8, Zeile 2; Abbildungen 7-9,15 * | 1 | G 01 R 15/02 |
| A | | 2-4 | |
| | – – – | | |
| D,A | WO-A-8 701 812  (LANDIS & GYR) | | |
| | – – – | | |
| A | FR-A-2 537 285  (LA TELEMECANIQUE) | | |
| | – – – | | |
| D,A | EP-A-0 262 293  (LANDIS & GYR) | | |
| | – – – – – | | |

|  | RECHERCHIERTE SACHGEBIETE (Int. Cl.5) |
|---|---|
| | G 01 R<br>H 01 F |

**Der vorliegende Recherchenbericht wurde für alle Patentansprüche erstellt**

| Recherchenort | Abschlußdatum der Recherche | Prüfer |
|---|---|---|
| Den Haag | 28 Mai 91 | IWANSSON K.G. |